# EUROPEAN PATENT SPECIFICATION

(11) **EP 4 605 763 B1**
(45) Date of publication and mention of the grant of the patent: **30.09.2026**
(21) Application number: 24789889.3
(22) Date of filing: 11.10.2024
(51) Int. Cl.: G01R 31/265

(54) **CONTACTLESS MEASUREMENT OF EFFECTIVE ELECTRIC PROPERTIES OF SURFACE LAYERS OF SEMICONDUCTORS**
KONTAKTLOSE MESSUNG DER EFFEKTIVEN ELEKTRISCHEN EIGENSCHAFTEN VON OBERFLÄCHENSCHICHTEN VON HALBLEITERN
MESURE SANS CONTACT DES PROPRIÉTÉS ÉLECTRIQUES EFFECTIVES DE COUCHES DE SURFACE DE SEMI-CONDUCTEURS

(30) Priority: 16.11.2023 EP 23210447
(43) Date of publication of application: 27.08.2025
(73) Proprietor: Centre de Coopération Technique et Pédagogique ASBL, 4100 Seraing (BE)
(72) Inventor: JAMOTTON, Elodie, 4000 Liège (BE); SCHEEN, Gilles, 3840 Welkenraedt (BE); BROSE, Christophe, 4260 Braives (BE); BROUN, Valéry, 4400 Flémalle (BE)
(74) Representative: Calysta NV
(86) International application number: PCT/EP2024/078731
(87) International publication number: WO 2025/103672

(56) References cited:
- US-A1- 2010 153 033
- US-A1- 2021 126 581
- US-B1- 9 103 659

## Description

### Technical Field

The present invention relates to contactless measurement of effective electric properties of surface layers of semiconductors.

### Prior art

Radiofrequency (RF) electronic circuits are built on semiconductor substrates, which essentially serve as a mechanical support during circuit fabrication. However, at high frequencies, several parasitic phenomena appear in these substrates, in the vicinity of the circuits. These phenomena result in power losses, signal distortion and crosstalk between different parts of the circuits, resulting in a significant degradation of the RF performance of microelectronic circuits.

To overcome these parasitic phenomena, the industry is developing new substrate technologies using thin-film stacking (of the order of 100 nm to a few microns thick) to minimize or eliminate these phenomena. For example, benchmark technology for a semiconductor substrate stack 10, currently found in most smartphones, consists of a high-resistivity silicon substrate 11 on which a layer of polysilicon 12 (called the trap-rich layer) and a layer of silicon oxide 13 (called the BOX layer) are deposited. In this technology, the trap-rich layer traps the accumulation of electrical charges produced by the presence of the BOX layer 13, necessary for RF circuits. Without this trap-rich layer 12, the substrate 11 would be responsible for very high losses in RF circuits.

This trap-rich layer 12 is complex to produce and requires excellent quality. To ensure the quality of their substrates 10, RF substrate manufacturers need to check the electrical properties of these thin films.

There are basically two families of semiconductor substrate characterization techniques available on the market.

The first is contact measurement techniques. Characterization devices are placed on a number of substrates removed from the production line (statistical approach). These selected substrates are then tested thanks to the characterization devices. From the obtained measurements, the electrical properties of thin films are extracted thanks to a model of the existing interactions. A major issue is that the substrates with characterization devices can no longer be used as the characterization devices cannot be removed any more without destructing the substrate. Therefore, this is very costly, and it is not possible to use it in-line. Not all the substrates produced can be tested.

The second family includes non-destructive techniques, preferably contactless techniques such as photoconductance, spectroscopy, capacitive measurements, and resonant cavity measurements. These techniques have the advantage of not modifying the tested substrate, which can then be used to manufacture RF circuits. On the other hand, they have the disadvantage of measuring the electrical properties of the entire thickness of the substrate, or at least a large part of it (several hundreds of microns). The electrical properties of only a small layer can't be extracted yet using such non-destructive type.

In the field of photoconductance measurement, there are several techniques known which illuminate the photoconductive semiconductor material with light in order to measure the photoconductance, e.g. US2010/01530331A1, US2021/0126581, US9103659B1. However, those techniques do not allow to verify the quality of a top layer(s) of the above-described high-resistive substrates.

### Brief summary of the invention

It is the object of the invention to provide an improved technology for a non-destructive measurement of electric properties of semiconductor samples

According to the invention, this object is solved by a system according to claim 1, a method according to claim 14 and a computer program according to claim 15.

The invention uses the effect that light penetrates a semiconductor only up to a penetration depth and changes the electrical properties of a sub-layer defined by this penetration depth by photogeneration of electrical charge carriers. When measuring the electrical parameter once with light and once without light, the effective electrical property of the sub-layer can be determined on these two values. By properly choosing the wavelength of the illumination light, the penetration depth and thus the sub-layer to be measured can be defined. This allows to make measurements of the effective electrical properties of sub-layers of semiconductor substrates in a contactless manner and/or without destructive measurement means. This allows an immense improvement of the quality control of produced semiconductor samples/substrates as they can all be measured/controlled without the destruction of samples and without the statistical errors of previous quality control.

The dependent claims refer to further advantageous embodiments.

In one embodiment, the illumination means is configured to illuminate the measurement zone with at least two different light spectra comprising a first light spectrum and a second light spectrum, wherein the system or measurement apparatus is configured to measure the second value of the electrical parameter with an illumination with the light of first light spectrum, wherein the system is configured to measure a third value of the electrical parameter with an illumination of the measurement zone with the light of the second light spectrum. This allows to change penetration depth of the light used and thus to change the thickness of the sub-layer to be measured. Three or more thicknesses can be measured by increasing the number of light spectra to three or more. The different light spectra could be achieved by switching the light source or filter (discrete spectra selection) or by selecting a specific spectra of a broad light spectra (continuous spectra selection).

In one embodiment, the processing means or computer program is configured to determine the electrical property of the sub-layer of a first thickness of the semiconductor sample based on the first value and the second value, and to determine the electrical property of the sub-layer of a second thickness of the semiconductor sample based on the first value and the third value. This allows determine the effective electrical property of different thicknesses of the sub-layer.

In one embodiment, the processing means is configured to determine the electrical property of a deep-layer based on the first value, the second value and the third value. By combining the different values measured with different light spectra, i.e. with different penetration depths, it is also possible to determine the electrical properties of sub-layers which lay deeper under the surface.

In one embodiment, the system or measurement apparatus is configured to change a light spectrum or light wavelength of the light of the illumination means in order to change the thickness of the sub-layer whose electrical property is measured. This allows to measure different thicknesses of sub-layers.

In one embodiment, the illumination means is configured to generate light with a wavelength above 100 nm and/or below 1000 nm. These light wavelengths have been found to work particularly well for the most common semiconductor materials.

In one embodiment, the electrical property of the sub-layer determined represents the electrical property of the sub-layer without the influence of the light illumination. The first and second value are combined such that the resulting electrical property represents the electrical property of the sub-layer without the influence of the illuminated light.

In one embodiment, the contactless measurement means is configured to apply an electric and/or magnetic field in the measurement zone and measure at least one intermediate parameter based on the influence of the semiconductor sample on the applied electric and/or magnetic field, wherein the electrical parameter corresponds to the at least one intermediate parameter or is computed based on the at least one intermediate parameter. Most contactless measurement means for measuring electrical parameters of semiconductors work with electric and/or magnetic fields.

In one embodiment, the electric and/or magnetic field applied is an alternating electric and/or magnetic field.

In one embodiment, the contactless measurement means comprises at least one field device configured to generate or apply an alternating electric and/or magnetic field in the measurement zone and to measure at least one intermediate parameter based on the influence of the semiconductor sample on the generated or applied electric and/or magnetic field. The at least one field device of the contactless measurement means thus actively generates the alternating electric and/or magnetic field. In one embodiment, the contactless measurement means is configured to vary the frequency of the applied electric and/or magnetic field in the measurement zone and to measure the intermediate parameter at the different varied frequencies.

In one embodiment, the contactless measurement means comprises a first field device arranged in the measurement zone above the semiconductor sample on the surface side of the semiconductor sample illuminated by light, wherein the contactless measurement means comprises a second field device arranged in the measurement zone below the semiconductor sample on the side opposed to the surface side illuminated by light, wherein the first field device and the second field device are configured to apply the electric and/or magnetic field and to measure the intermediate parameter.

In one embodiment, the electric and/or magnetic field is applied on one of the first and second field device and the electrical parameter is measured on the same one and/or on the other of the first and second field device.

In one embodiment, the contactless measurement means is configured to measure the four S-parameters by applying the electric and/or magnetic field on the first field device and measuring it on the first and second field device and by applying the electric and/or magnetic field on the second field device and measuring it on the first and second field device.

In one embodiment, the first field device and the second field device are dielectric resonators.

In one embodiment, the contactless measurement means is configured to apply an (alternating) electrical and/or magnetic field which extends over the complete thickness of the semiconductor substrate.

In one embodiment, the first value measured without the light illumination represents (is indicative for) the electrical parameter for the complete thickness of the semiconductor sample, wherein the second value measured with a light penetrating in the sub-layer of the semiconductor and/or being absorbed therein represents (being indicative for) the electrical parameter in the semiconductor substrate outside of or below the sub-layer, wherein the electrical property is obtained by combining the first value and the second value of the electrical parameter such that the electrical property of the sub-layer is obtained.

In one embodiment, the semiconductor sample comprises a first layer and at least one surface layer, wherein the first layer has a resistivity larger than 1 kiloohmcentimeter, wherein the at least one surface layer is arranged on top of the first layer, wherein the at least one surface layer is thinner than the first layer.

In one embodiment, the at least one surface layer comprises a second layer and a third layer, wherein the third layer is a box layer, wherein the second layer is arranged between the first layer and the third layer, wherein the second layer is preferably a trap-rich layer to trap the accumulation of electrical charges produced by the presence of the box layer.

In one embodiment, the sub-layer corresponds to one or more of the at least one surface layer. In other words, the wavelength of the light is chosen such that the penetration depth corresponds substantially to the interface between the first layer and the at least one surface layer.

In one embodiment, the semiconductor sample is a semiconductor substrate used to mount MEMS circuits or semiconductor circuits on the semiconductor substrate.

In one embodiment, the contactless measurement means is a resonant measurement means configured to measure the electrical parameter in a frequency range of the applied electric and/or magnetic field comprising the resonant frequency of the contactless measurement means, preferably the resonant frequency of the measurement system consisting of the first and second field device.

In one embodiment, the contactless measurement means is split-post dielectric resonator. In one embodiment, the processing means of the system is a software (computer program).

In one embodiment, the processing means or computer program is configured to control the measurement apparatus or to control the contactless measurement means and the illumination means to perform the measurement of the first and second value.

In one embodiment, the system or measurement apparatus comprises a support for holding the semiconductor sample (or a part of it) in a measurement zone.

In one embodiment, the system comprises a measurement apparatus comprising the illumination means and the contactless measurement means.

In one embodiment, the processing means is arranged in the measurement apparatus.

In one embodiment, the processing means is arranged in a distinct device. The distinct device could be a local computer connected to the measurement apparatus or could be a remote server or something else.

Other embodiments according to the present invention are mentioned in the appended claims and the subsequent description of an embodiment of the invention.

### Brief description of the Drawings

Fig. 1 is a cross-section view of an exemplary silicon substrate.
Fig. 2 shows schematically the absorption depth of different light wavelengths in the substrate shown in Fig. 1.
Fig. 3 shows a diagram of the absorption depth of silicon over the wavelength of the illumination light.
Fig. 4 shows a first example of an absorption layer.
Fig. 5 shows a second example of an absorption layer.
Fig. 6 shows schematically an embodiment of a system for measuring electric properties of an absorption layer of a semiconductor sample.
Fig. 7 shows a split post dielectric resonator (SPDR) according to the prior art.
Fig. 8 shows an example realization of the measurement apparatus with an adapted SPDR as contactless measurement technology.
Fig. 9 shows the electrical field in a part of the measurement zone for the example in Fig. 8.

In the drawings, the same reference numbers have been allocated to the same or analogue element.

### Detailed description of an embodiment of the invention

Other characteristics and advantages of the present invention will be derived from the non-limitative following description, and by making reference to the drawings and the examples.

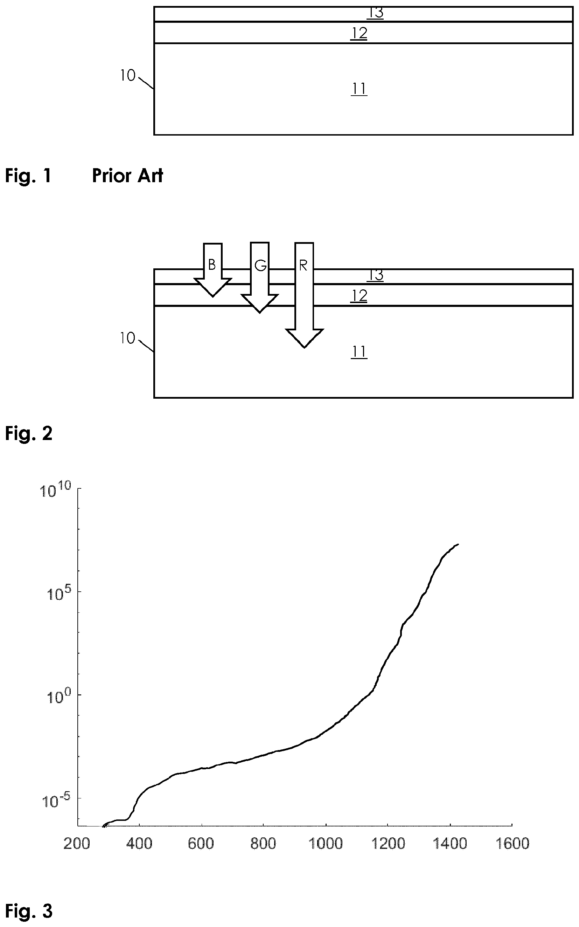

The invention aims to measure the effective electrical properties of a sub-layer of a semiconductor sample 10 like the one shown for example in Fig. 1.

The semiconductor sample 10 has preferably a plate like structure with a normal direction of the plate. The semiconductor sample 10 comprises preferably at least two layers, preferably three or more layers. The layers 11, 12, 13 are preferably stacked in a stacking direction or in the normal direction or in a direction perpendicular to the (top) surface of the sample 10. The layers 11, 12, 13 comprise preferably a bottom or first layer 11 responsible for the structural stability of the sample and to support mechanically the components or circuits on the semiconductor sample 10. The first layer 11 is preferably a high resistive silicon, preferably larger than 1kiloohmcentimeter (kΩcm), preferably larger than 4 kΩcm. Preferably, at least one surface layer 12, 13 is arranged on top of the first layer 11 to obtain the required electrical properties for the semiconductor sample 10 on its top surface, where preferably electrical circuits are arranged. The at least one surface layer 12, 13 is preferably thinner than the first layer 11. The at least one surface layer 12, 13 comprises preferably a third layer 13 arranged in this embodiment on the surface of the sample 10. The third layer 13 is preferably a box layer and/or a silicon oxide layer or another semiconductor material oxide layer. Preferably, the sample 10 or the at least one surface layer 12, 13 comprises a second layer 12 arranged between the first layer 11 and the third layer 13. This second layer 12 is preferably a trap-rich layer. The trap-rich layer 12 has the function to trap the accumulation of electrical charges produced by the presence of the BOX layer 13. The semiconductor sample 10 could comprise additionally a fourth layer (not shown) on top of the third layer 13. The fourth layer on top of layer 13 is made preferably out of the same material as the first layer 11 and/or is made of semiconductor material, preferably made of silicon.

The first layer 11 has preferably a thickness larger than 150 micrometer (µm) and/or smaller than 2000 µm, preferably smaller than 1000 µm. The at least one surface layer 12, 13 (together) has preferably a thickness larger than 80 nanometers (nm), preferably than 200 nm, preferably than 300 nm, preferably than 400 nm, preferably than 450 nm and/or has preferably a thickness smaller than 4 µm, preferably than 3 µm, preferably than 2.5 µm, preferably than 2 µm, preferably than 1.5 µm. The third layer 13 has preferably a thickness larger than 15nm, preferably than 20nm, preferably than 30nm, preferably than 40 nm, preferably than 60 nm, preferably than 80 nm and/or has preferably a thickness smaller than 500 nm, preferably than 450 nm, preferably than 400 nm. The second layer 12 has preferably a thickness larger than 200 nm, preferably than 300 nm, preferably than 400 nm and/or has preferably a thickness smaller than 3 µm, preferably than 2.5 µm, preferably than 2 µm. The thickness is the dimension in the stacking direction and/or in the normal direction. The optional fourth layer has a thickness which is preferably larger than 5 nm, preferably than 10 nm, preferably than 15nm, preferably than 20nm and/or is preferably smaller than 50 nm, preferably than 40 nm, preferably than 35 nm, preferably than 30 nm.

The semiconductor sample 10 is preferably a semiconductor substrate 10 used to mount electric circuits on the semiconductor substrate 10 or on its third layer 13, e.g. MEMS circuits or semiconductor circuits. The invention is particularly interesting for measuring the electrical properties of one or more of the at least one surface layer 12, 13.

The invention allows thus for such a semiconductor sample 10 described to measure effective electrical properties of the third layer 13 or the third layer 13 plus second layer 12 or just the second layer 12. Even though the invention is particularly well suited to measure these types of semiconductor substrates 10. They could be used equally for other semiconductor substrates or samples. For example, other semiconductor materials could be used in the layers. Also, other types of layers could be used with other electrical characteristics. It is also possible to use the invention with semiconductor samples 10 without different layers.

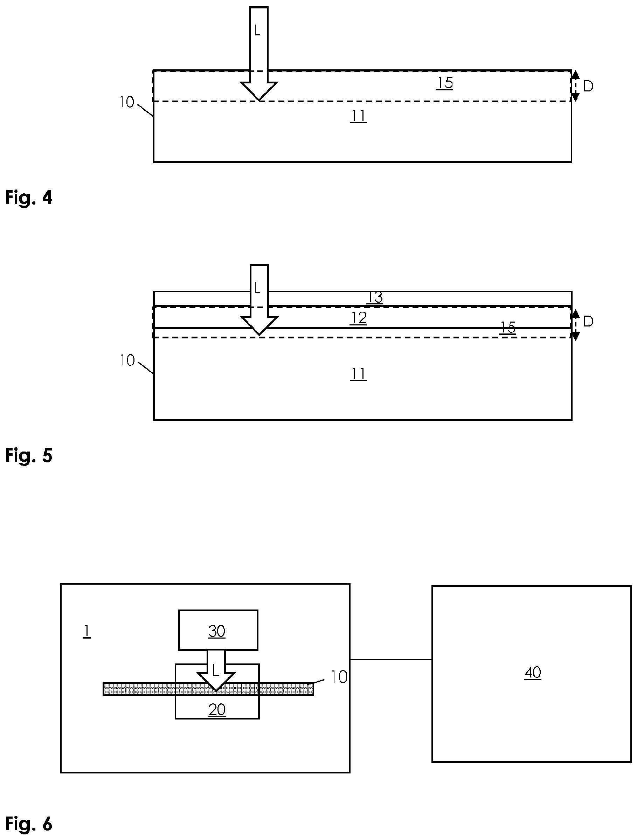

Fig. 2 and 3 show the physical phenomena used in the present invention. Light penetrates a semiconductor up to a certain penetration depth. Up to this penetration depth, the light produces photogeneration of electrical charge carriers in the semiconductor material, thus modifying its electrical properties within the semiconductor layer defined by the penetration depth. The penetration depth of the semiconductor material is known. For example, Fig. 3 shows the penetration depth curve of light for silicon over the wavelength of the illumination light. The y-axis shows logarithmically the penetration depth in cm, while the x-axis shows wavelength in nm. The penetration depth in Fig. 3 is defined as the depth at which the intensity of the light inside the material falls to 1/e (about 37%) of its original value at (or more properly, just beneath) the surface. It can be seen that the penetration depth at a wavelength of 400 nm is about 100 nm, at a wavelength of 500 nm is about 1 µm, at a wavelength of 800 nm is about 10 µm. Thus, by selecting the right wavelength, it could be controlled up to which penetration depth electrical charge carriers are generated by photogeneration in the semiconductor substrate 10. This is shown exemplarily in Fig. 2. E.g. the absorption depth of blue light B, e.g. 450 nm, is limited to the third layer 13, while the penetration depth of green light G, e.g. 525 nm, would cover in this example the third layer 13 and the second layer 12, and the penetration depth of red light R, e.g. 625 nm, would also go deeper into the substrate 10, i.e. also in the first layer 11. It is clear that the penetration depth curve over the wavelength will change for other semiconductor materials. For example, for Gallium nitride (GaN) lower wavelengths need to be used to achieve similar penetration depths. The invention uses now this photogeneration effect to measure an effective electrical property of a sub-layer 15 of the semiconductor substrate 10. The measured sub-layer corresponds to the layer of the semiconductor sample 10 in which the electrical characteristics are changed by photogeneration of electrical charge carriers by the penetrating light L. This sub-layer will subsequently also be called as absorption layer 15 of the semiconductor sample/substrate 10, as it is this layer absorbing the penetrated light L in order to generate the charge carriers. The absorption layer 15 has nothing to do with a material layer 13, 12, 11 of the semiconductor substrate 10, but is only defined by the light penetration in the semiconductor sample 10. This does obviously not exclude that the lower border of the absorption layer 15 of the semiconductor substrate 10 could coincide with a border between two "material" layers of the semiconductor substrate 10, e.g. the border between the first layer 11 or the second layer 12, to the contrary, this is actually desired to measure the electrical properties of the first layer 12 or of the third layer 13 or of both. The absorption layer 15 normally extends from the top surface, where the light L penetrates into the semiconductor sample 10 down to the penetration depth D as exemplary shown for a semiconductor substrate 10 consisting only of a simple silicon layer 11 in Fig. 4. As can be seen in this example, the absorption layer 15 corresponds to a sublayer of the first layer 11. However, one or more of the "material" layers on the top of the semiconductor sample 10 might be transparent to the light L so that the absorption layer 15 might correspond actually to a deeper layer 15 with the thickness D. For example, the silicon oxide layer 13 is normally transparent to light so that the absorption layer 15 starts normally only with the trap-rich layer 12 as shown in Fig. 5. Thus, the absorption layer 15 would extend from the trap-rich layer 12 down to a thickness corresponding to the penetration depth D of the light L in the semiconductor material used. In the shown example, the absorption layer 15 corresponds to the second layer 12 and a bit of the upper part of the first layer 11. Thus, by choosing the wavelength of the light L, the penetration depth D could be chosen such that the absorption layer 15 corresponds to the trap-rich layer 12. Thus, by choosing the wavelength, the sub-layer 15 to be measured can be chosen. Also, a semiconductor layer on top of the third layer 13 is normally transparent to light L due to its low thickness. Thus, in the described semiconductor substrate 10, the trap-rich layer 12 can be measured well by the absorption layer 15 if the wavelength of the penetration light L is well chosen. The same holds obviously for other semiconductor samples with other layer stacks. If such a semiconductor layer stack comprises at least one intermediate layer which is transparent to the penetration light, it might also be that the measured absorption layer comprises at least two separated sub-layers. Thus, it can be resumed that the absorption layer 15 extends from the top surface of the semiconductor substrate 10 down to the penetration depth of the light L in the semiconductor substrate 10 (eventually subtracting the light transparent layers in this penetration depth). The penetration depth of the light L in the semiconductor substrate 10 or semiconductor stack corresponds normally to the penetration depth D of the light L in the semiconductor material used (e.g. silicon) eventually plus the thickness of the light transparent layers. Obviously, the penetration depth of the light L in the special stacking of the semiconductor sample 10 could be more complex and could be calculated by more complex calculations or simulations.

The invention uses now this photogeneration effect in the absorption layer 15 to measure an electrical parameter of the semiconductor substrate 10 first without light on the (top) surface of the substrate 10 and second with light illumination on the (top) surface of the substrate 10. The first measurement measures a first value of the electrical parameter of the semiconductor substrate 10. The second measurement measures also a second value of the electrical parameter of the semiconductor substrate, however with changed electrical characteristics in the absorption layer 15. Based on these two measurements, an effective electrical property of the absorption layer 15 of the semiconductor sample 10 can be calculated. This can be explained with a simplified example. Let's assume, the electrical parameter is the resistivity of the semiconductor substrate 10. Since the electrical charge carriers photogenerated reduce the resistivity of the absorption layer 15 in which the photogeneration happens, the second measurement with light in first approximation measures the effective resistivity of the lower part of the semiconductor sample 10 which is not reached by the illumination light L. Thus, in first approximation the difference of the two measurements provides the effective resistivity of the absorption layer 15. Similar reasonings can be made for other electrical parameters measured normally in contactless measurements, e.g. Q-factor.

Fig. 6 shows a schematic system according to the invention. The system comprises a measurement apparatus 1 and a processing means 40.

The measurement apparatus 1 is configured to receive the semiconductor sample 10 for the measurement. The measurement apparatus 1 is preferably configured to have a measurement zone in which the measurement of the effective electrical property and/or the electrical parameter of the semiconductor sample 10 is measured. The measurement zone of the semiconductor sample 10 is intended to the portion in the plane of the semiconductor substrate 10 which is measured, i.e. the measurement zone refers to the two dimensions parallel to the plane of the semiconductor substrate 10. The measurement zone dimensions are thus perpendicular to the stacking direction of the semiconductor substrate 10 and/or to the penetration depth D of the light L (or thickness of the absorption layer 15). Preferably, the measurement apparatus 1 is configured for inline measurement of semiconductor samples 10 in a manufacturing line of the semiconductor samples 10 so that each semiconductor sample 10 of the manufacturing can be measured. This measurement is preferably done before the electrical circuits and/or components are arranged on the top surface of the semiconductor sample 10. The inline measurement could actually also be done during the manufacturing process of the substrate 10 itself. E.g. the trap-rich layer 12 could be measured before the BOX layer 13 is generated on top of it.

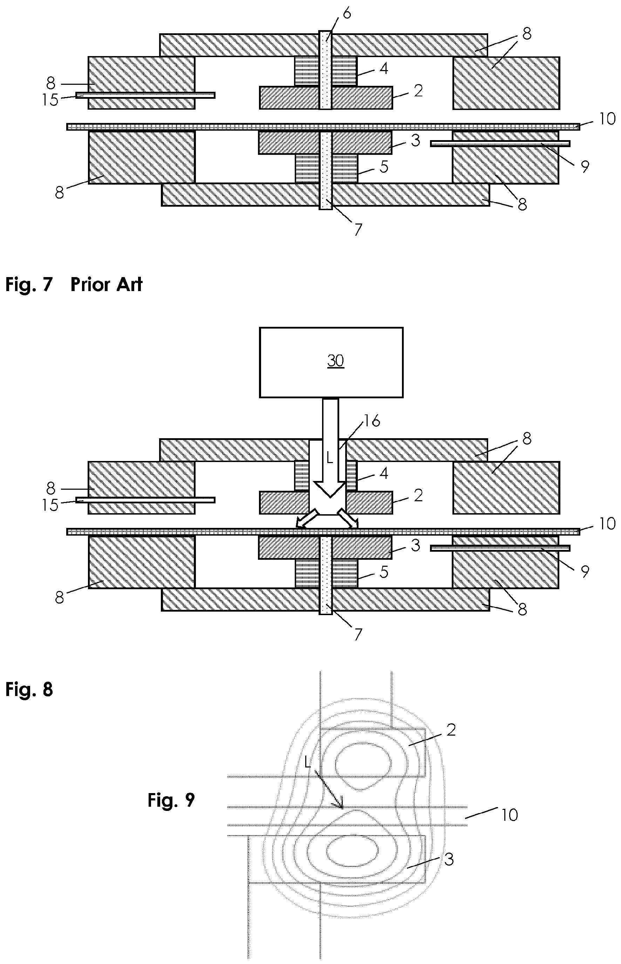

The measurement apparatus 1 comprises a contactless measurement means 20 and a light illumination means 30. Fig. 8 shows an example of the contactless measurement means 20 which uses a Split-Post Dielectric Resonator (SPDR) for measuring the electrical parameter. The SPDR of the state of the art shown in Fig. 7 was adapted for the present invention to allow a light illumination in the measurement zone. SPDR is only one contactless measurement technique for measuring the electrical parameter. Other measurement techniques can equally be used. Subsequently, preferred embodiments of the contactless measurement means 20 are described in general.

The contactless measurement means 20 is configured for measuring an electrical parameter of the semiconductor sample 10 (in the measurement zone). Examples of the electrical parameter are the resistivity, the conductivity, the Q-factor, the reduction of an electric or magnetic field at a certain frequency or over a frequency range, etc. The measured electrical parameter depends obviously also on the measurement technique used. The contactless measurement means 20 sometimes measures the electrical parameter of the complete thickness of the semiconductor sample 10 (in the measurement zone and/or with or without light on its top surface), e.g. for SPDR. In other embodiments, the contactless measurement means 20 measures only a portion of the thickness of the semiconductor sample 10 being however thicker than the absorption layer 15.

The contactless measurement means 20 is preferably configured to compute or measure the electrical parameter independent from a measurement of the light L reflected from or transmitted through the semiconductor sample 10.

The contactless measurement means 20 is preferably configured to compute or measure the electrical parameter independent from a modulation of the light L penetrating the absorption layer 15. Preferably, the light is illuminated constantly during the measurement of the second value and the light is switched completely off during the measurement of the first value. Preferably, the light is not periodically switched on and off.

The contactless measurement means 20 is preferably configured to apply an electric and/or magnetic field in the measurement zone.

The electric and/or magnetic field is preferably an alternating electric and/or magnetic field, i.e. an electric and/or magnetic field which periodically changes its amplitude, preferably also its direction/polarity. Preferably, the alternating electric and/or magnetic field changes with a sinus function, however obviously also other periodically changing fields are possible. The contactless measurement means 20 is preferably configured to apply an alternating electric and/or magnetic field with a frequency above 100 Megahertz (MHz), preferably above 500 MHz, preferably above 700 MHz, preferably above 1 Gigahertz (GHz), preferably above 2 GHz, preferably above 3 GHz, preferably above 4 GHz and/or with a frequency below 15 GHz, preferably below 10 GHz, preferably below 7 GHz, preferably below 6 GHz. But the field frequency could also be higher or lower than these frequencies. Depending on the application of the semiconductor sample 10, other field frequencies can be used.

The contactless measurement means 20 is further configured to measure during the application of the (alternating) electric and/or magnetic field at least one intermediate parameter based on the influence of the semiconductor sample 10 on the applied electric and/or magnetic field. The electrical parameter measured either corresponds to the at least one intermediate parameter or is computed based on the at least one intermediate parameter. The intermediate parameter could be for example the attenuation of the electric and/or magnetic field when the semiconductor sample 10 is placed in the measurement zone. This could be used directly as the electrical parameter. In another example, this attenuation or another intermediate parameter is measured for different frequencies of the alternating electric and/or magnetic field to obtain a (attenuation or intermediate parameter) curve over the field frequency. The measured frequency range is chosen preferably around a resonant frequency of the contactless measurement means 20, e.g. of the at least one field device 2, 3 described below. The contactless measurement device 20 could thus measure a parameter of the resonance peak when the semiconductor sample 10 is in the measurement zone, once without light penetration (first value) and once with light penetration (second value). The contactless measurement device 20 could thus measure the change of the resonance peak of the at least one field device 2, 3 when the semiconductor sample 10 in the measurement zone is illuminated with the light L. The Q-factor $Q = \frac{{f}_{0}}{Δf}$ can for example be calculated from the attenuation curve over the field frequency by the frequency of the resonance frequency f0 of the at least one field device 2, 3 with the semiconductor sample 10 in the measurement zone divided by the half-width f of the resonance peak. The Q-factor could be the parameter of the resonance peak. The Q-factor shows how lossy the system is and can thus as well be considered as the electrical parameter. In this example, the contactless measurement means 20 could measure the attenuations for different field frequencies as intermediate parameters and compute the Q-factor as electrical parameter.

The contactless measurement means 20 comprises preferably at least one field device 2, 3 to generate the (alternating or non-alternating) electric and/or magnetic field. The at least one field device 2, 3 is preferably arranged in the measurement zone below and/or above the semiconductor substrate 10. Preferably, the at least one field device 2, 3, comprises a first field device 2 arranged in the measurement zone above the semiconductor sample 10 on the side of the absorption layer 15 and a second field device 3 arranged in the measurement zone below the semiconductor sample 10 on the opposed side. However, there are also some measurement techniques which require only the first field device 2 or the second field device 3. The one or two field devices could also be arranged differently. The at least one field device 2, 3 is preferably also configured to measure attenuation of the electric and/or magnetic field or other intermediate parameters. If there is only one field device 2, 3, the attenuation of the field is measured in the same field device 2, 3 which generates the field. If there are two field devices 2, 3, it is possible to generate the field on one field device 2, 3 and measure the attenuation on the other one of the field devices 2, 3 (transmission measurement) or to measure attenuation of the same field device 2, 3 which generates the field (reflection measurement). In some embodiments all four S-parameters are measured, generation of the field at the first field device 2 and measurement at the first field device 2 (S11), generation of the field at the first field device 2 and measurement at the second field device 3 (S12), generation of the field at the second field device 3 and measurement at the first field device 2 (S21), generation of the field at the second field device 3 and measurement at the second field device 3 (S22). Thus, in the example described above, the attenuation curve over the field frequency would be measured in those four configurations and four different Q-factors could be determined. However, obviously simpler measurement technologies with only one field device 2, 3 could be used as well. The material of the field devices 2, 3 depend on the electric and/or magnetic field characteristics which need to be achieved. For the SPDR, the field devices 2 and 3 are made of dielectric materials which are excited by coupling loops 9 and 15. The first coupling loop 15 is configured to excite the first field device 2 and/or to measure the attenuation at the first field device 2. The second coupling loop 9 is configured to excite the second field device 3 and/or to measure the attenuation at the second field device 3. These dielectric materials have preferably electric permittivity above 10, preferably above 20, preferably above 25. The at least one field device 2, 3 is designed such that they have a resonance frequency in the frequency range of interest for the semiconductor sample 10. It is clear that the at least one field device 2, 3 could also be realized in conductive materials or other materials for other types of electric and/or magnetic fields.

Subsequently, the preferred contactless measurement means, the SPDR in Fig. 8 is described. The SPDR comprises a first dielectric field device 2 arranged above the semiconductor sample 10 and a second dielectric field device 3 arranged below the semiconductor 10 (both in the measurement zone). The field devices 2, 3 and/or the measurement zone is enclosed in a metallic cavity formed by the metallic elements 8. The field devices 2, 3 are supported by further dielectric support elements 4 and 5 which fix the field devices 2, 3 to the metallic cavity 8. While the state-of-the-art cavity was closed and/or the opening 6 was too small to enter light in the measurement zone on the top surface of the semiconductor sample 10 (see Fig. 7), the SPDR of the invention was varied such that the light L from the illumination means 30 could be brought to the measurement zone on the top surface of the semiconductor sample 10. Therefore, the opening 16 was increased with respect to the opening 6 of the state of the art and with respect to the opening 7. The opening 16 extends preferably through the field device 2 (here also through the dielectric element 4 and the metal top cover plate 8). The opening 16 is preferably arranged in the center of the first field device. The first field device 2 has preferably a circular shape and the opening 16 is preferably also circular arranged coaxially with the same center point of the circles. The diameter of the opening 16 is arranged preferably larger than a diameter of an opening in the second field device 3 (if there is any). For an SPDR with a resonance frequency of around 5GHz, the opening 16 should have a diameter smaller than 6 mm, preferably smaller than 5 mm, preferably smaller than 4,5 mm. The increased opening allows to arrange light guide means in the opening 16 which make the light L enter in a flat angle with respect to the semiconductor surface so that preferably the complete measurement zone is illuminated, but also the light enters in an angle which is not reflected from the semiconductor material. Preferably, the light L enters the measurement zone preferably with an angle smaller than 40°, preferably than 30°, preferably than 25°, preferably than 22°, preferably than 20° with respect to the surface of the semiconductor sample 10. Notwithstanding the new asymmetry between the first and second field device 2, 3, the measurement results remained still correct. Fig. 9 shows the electrical field generated by the field devices 2 and 3. The measurement zone is where the main electrical field develops, i.e. in the (ring) zone where the two field devices 2, 3 overlap. As shown in Fig. 9, the light L is inserted such in the opening 16 that it optimally illuminates the complete measurement zone. The central opening 16 is only one way to illuminate the measurement zone. It would also be possible to make multiple smaller openings in the upper field device 2 to insert light through them into the measurement zone. It would also be possible to use transparent materials for the field device 2.

If the current SPDR would be used in an inline measurement, the sample 10 could enter the SPDR from the right and exit to the left or vice versa. It could also enter the SPDR from the front and exit to the back or vice versa.

Instead of SPDR, alternative contactless measurement technologies for the contactless measurement means 30 are described below.

Eddy currents can be used to measure the electrical parameter of the semiconductor substrate 10.

Eddy currents are induced in a conductive material if an oscillating magnetic field surrounds the conductive material. Those currents are rotating in the material in a way that counters the magnetic field variation seen by the conductive material. Thus, the resulting magnetic field is changed. The penetration depth and the intensity of eddy currents depend on several parameters of the oscillating magnetic field but also of the material in which they are induced. This can be used to measure the electrical parameter of the semiconductor substrate 10. In this case only one field device is needed (even though it would work also with two). The field device generates an oscillating magnetic field in the vicinity of the measurement zone. The field device is for example a coil. The oscillating magnetic field will induce Eddy currents in the semiconductor sample 10 in the measurement zone. The Eddy currents in the semiconductor substrate 10 will again influence the current in the field device/coil which can then be measured. This allows to measure the electrical parameter.

Capacitive changes can be used to determine the electrical parameter of the semiconductor sample 10. A capacitor is composed of two metallic parts separated by medium in which an electric field propagates. If the medium properties are changed, the way electric field is distributed and the losses in the propagating medium are changed too. These variations in the electric field can be measured through the capacitor impedance or through the resonance parameters of a resonating circuit in which only the capacitor will change. Instead of placing the two capacitive plates on two opposed sites of the semiconductor substrate 10, they could be arranged in a parallel-plate capacitor, i.e. both capacitor plates on the top side of the semiconductor substrate 10 (parallel to its surface). The highest field is achieved between the two capacitor plates so that the light L can easily be inserted between the two capacitor plates in the measurement zone.

The illumination means 30 is configured to illuminate the measurement zone with light L during the measurement of the electrical parameter by the contactless measurement means 20. The illumination means 30 is configured to illuminate the top surface of the semiconductor sample 10 in the measurement zone while the contactless measurement means 20 performs a measurement of the electrical parameter of the semiconductor sample 10 in the measurement zone.

The light L has preferably a wavelength above 100 nm, preferably above 200 nm, 300 nm, preferably above 350 nm, preferably above 400 nm and/or a wavelength below 1000 nm, preferably below 900 nm, preferably below 800 nm, preferably below 700 nm. Thus, the illumination light is preferably in the visible range. The illumination means 30 is preferably configured to change the light spectrum of the light L, preferably to change the wavelength or color of the light L. Preferably, each light spectrum has a bandwidth smaller than 100 nm, preferably than 50 nm, preferably than 30 nm so that each light spectrum refers to a different color or wavelength. The different light spectra comprise preferably at least two, preferably at least three different colors in the visible range, preferably from blue B, green G and red R. In a preferred embodiment, the light L could be switched between different light spectra, e.g. by switching between different light emitting diodes (LED) or different lasers. However, it is also possible to have more light spectra and/or to tune the light spectrum continuously to have a finer selection of the desired light spectrum. This could be achieved by a light source with a broad spectrum. The spectrum/wavelength can then be selected by a tunable filter, e.g. a Fabry-Perot or a prism. By selecting the light spectrum, i.e. the wavelength of the light L, the absorption depth of the light L can be controlled. This allows thus to use the measurement apparatus 1 for measuring the effective electrical property of different surface thicknesses of the absorption layer 15 measured. However, in an application where the absorption layer 15 to be measured has always the same thickness, it would also be possible to use only one light spectrum which was optimized for the application. For example, for the semiconductor structure 10 described above, the light spectrum could be chosen such that the penetration depth corresponds to the depth of the interface between the first and second layer 11, 12 or such that the effective electrical property measured corresponds to the electrical property of the second layer 12.

The illumination means 30 could comprise further light guide means like optical fibers to guide the light L into the measurement zone.

The measurement apparatus 1 is configured to make at least two measurements with the contactless measurement means 20. A first measurement, for measuring a first value of the electrical parameter for the semiconductor sample 10 without any light L in the measurement zone (on the semiconductor sample 10). The first value and/or the electrical parameter can be a multidimensional value/parameter, e.g. could comprise four Q-factors for the four S-values or could comprise a plurality of attenuation values over a field frequency. A second measurement, for measuring a second value of the electrical parameter for the semiconductor sample 10, when the light L illuminates the measurement zone and/or the top surface of the semiconductor sample 10. The second value can be a multidimensional value, e.g. could comprise four Q-factors for the four S-values or could comprise a plurality of attenuation values over a field frequency. Preferably, the first value and the second value refer to the same measured electrical parameter. If the measurement apparatus 1 performs the measurement with different light spectra, the second value is measured for each different light spectrum, respectively. Preferably, the first measurement and the second measurement are done at the same location in the measurement zone, but one after the other (once without light L and once with light L illuminating the spot in the measurement zone). However, it would also be possible that the measurement zone has two measurement sub-zones, a first measurement sub-zone to realize the first measurement without any light illumination during the first measurement and with a second measurement sub-zone to realize the second measurement with a light illumination L of the second measurement sub-zone during the second measurement. This would allow to measure the first and the second value/measurement at the same time (if the first and second measurement sub-zone is far enough away that the light of the second measurement sub-zone does not influence the first measurement sub-zone.

The measurement apparatus 1 can be configured to measure a third value of the electrical parameter with a different light than the one used for the second value. The measurement apparatus 1 can be configured to measure multiple values of the electrical parameter with light of multiple different wavelengths/spectra.

The processing means 40 is configured to determine the (effective) electrical property of the absorption layer 15 of the semiconductor sample 10 based on the first value and the second value. The first and the second value are preferably processed digitally in the processing form, i.e. the first value and the second value are values digitally stored in the processing means 40 to compute the effective electrical property of the absorption layer 15. This absorption layer 15 might coincide with the third layer 13 or the combined layer 12 and 13 or just layer 12, but could also not coincide with the material layers as explained above. In the simplest case, the electrical property is determined by the difference of the first value and the second value of the electrical parameter. In the example above, the effective Q-factor of the surface layer could be calculated by the difference of the Q-factor measured without light and with light. However, it is also possible to provide more complex algorithms for computing the electrical property.

The electrical parameter is a parameter which is (significantly) reduced with generation of photo charges by the illumination with the light L. The electrical parameter is for example indicative of the resistivity of the material, e.g. the Q-factor. Consequently, the first value measured without the light L illumination represents the electrical parameter for the complete thickness of the semiconductor sample 10 (or at least for a thickness being larger or reaching lower than the absorption layer 15 as defined by the contactless measurement means 20). The second value measured with the light L penetrating in the absorption layer 15 of the semiconductor and being absorbed therein, represents the electrical parameter in the semiconductor substrate 10 outside of or below the absorption layer 15, because the light generates photo charges in the absorption layer 15 and thus reduces significantly the electrical parameter in the absorption layer, e.g. the resistivity or the Q-factor. Thus, the second value measured with the light L substantially represents the electrical parameter of the remaining layer(s) or thickness below the absorption layer 15. Thus, by combining the first value and the second value of the electrical parameter, the effective electrical property of the sub-layer can be computed. The first value and the second value are combined such that the effect of the electrical parameter measured below the absorption layer (second value) is removed from the electrical parameter representing the absorption layer 15 plus the measured layer below (preferably the complete thickness of the semiconductor substrate 10) so that an electrical property, e.g. the electrical parameter, of the absorption layer 15 is obtained. In first approximation, this can be realized by subtracting the second value from the first value. Considering however that the effect of the light does not stop exactly at one depth, but reduces exponentially with the depth, a more sophisticated formula can be used to remove the effect of the measurement with light (second value) from the measurement without light (first value) to obtain the effective electrical property of the absorption layer 15. The processing means 40 can be configured to compute the effective electrical property of deeper layers based on the first, second and third value. Based on the first and second value, the effective electrical property of a second absorption layer defined by the light used for the second value can be computed. Based on the first and third value, the effective electrical property of a third absorption layer defined by the light used for the third value can be computed. When the third value corresponds to a light which penetrates deeper than the light used for the second value, then the electrical value for a deep layer defined by the lower boundary of the second absorption layer and the lower boundary of the third absorption layer can be computed based on the electrical property of the second and third absorption layer, e.g. their difference, or based on the first, second and third value. When multiple values of the electrical parameter for multiple different wavelengths are measured, the effective electrical property of many different layers of the semiconductor substrate 10 can be determined.

The processing means 40 can be a general processing means running a software. It is however also possible that the processing means 40 is a special purpose processor. It is further possible that the processing means 40 is just the software, e.g. when the measurement apparatus 1 is sold together with a software 40.

It should be understood that the present invention is not limited to the described embodiments and that variations can be applied without going outside of the scope of the claims.

## Claims

1. System for measurement of an electrical property of a sub-layer (15) of a semiconductor sample (10):
a contactless measurement means (20) for measuring an electrical parameter of the semiconductor sample (10) in a measurement zone, wherein the contactless measurement means is configured to apply an alternating electric and/or magnetic field in the measurement zone and to measure an intermediate parameter based on the influence of the semiconductor sample on the applied electric and/or magnetic field, wherein the contactless measurement means (20) is configured to vary the frequency of the applied electric and/or magnetic field in the measurement zone;
an illumination means (30) for illuminating the measurement zone during the measurement with the contactless measurement means (20) with light (L), wherein the sub-layer (15) whose electrical property is measured corresponds to an absorption layer of the semiconductor sample (10) defined by the penetration depth of the light (L);
wherein the system is configured to measure a first value of the electrical parameter without an illumination of the measurement zone by the light (L) of the illumination means (30) and to measure a second value of the electrical parameter with an illumination of the measurement zone by the light (L) of the illumination means (30);
wherein a processing means (40) is configured to determine the electrical property of the sub-layer (15) of the semiconductor sample (10) based on the first value and the second value;
**characterized in that**
the contactless measurement means (20) is configured to measure the intermediate parameter at the different varied frequencies to obtain a curve over the field frequency, wherein the electrical parameter is computed based on the intermediate parameter at the different varied frequencies or is calculated based on the curve of the intermediate parameter.

2. System according to claim 1, wherein the illumination means (30) is configured to illuminate the measurement zone with at least two different light spectra (B, G, R) comprising a first light spectrum and a second light spectrum, wherein the system is configured to measure the second value of the electrical parameter with the illumination with the light (L) of the first light spectrum, wherein the system is configured to measure a third value of the electrical parameter with an illumination of the measurement zone with the light (L) of the second light spectrum, wherein the processing means (40) is configured to determine the electrical property of the sub-layer (15) of the semiconductor sample (10) of a first thickness (D) based on the first value and the second value, and to determine the electrical property of the sub-layer (15) of the semiconductor sample (10) of a second thickness based on the first value and the third value.

3. System according to claim 2, wherein the processing means (40) is configured to determine the electrical property of a deep-layer based on the first value, the second value and the third value.

4. System according to one of claims 1 to 3, wherein the system is configured to change a light spectrum or light wavelength of the light (L) of the illumination means (30) in order to change the thickness of the sub-layer (15) whose electrical property is measured.

5. System according to one of the claims 1 to 4, wherein the electrical property of the sub-layer (15) determined represents the electrical property of the sub-layer (15) without the influence of the light illumination.

6. System according to one of the claims 1 to 5, wherein the contactless measurement means (20) is configured to compute or measure the electrical parameter independent from a modulation of the light (L) penetrating the absorption layer (15).

7. System according to one of claim 1 to 6, wherein the semiconductor sample (10) comprises a first layer (11) and at least one surface layer (12, 13), wherein the first layer (11) has a resistivity larger than 1 kiloohm-centimeter, wherein the at least one surface layer (12, 13) is arranged on top of the first layer (11), wherein the at least one surface layer (12, 13) is thinner than the first layer (11).

8. System according to one of the claims 1 to 7, wherein the contactless measurement means (20) comprises a first field device (2) arranged in the measurement zone above the semiconductor sample (10) on the surface side of the semiconductor sample (10) illuminated by the light (L), wherein the contactless measurement means (20) comprises a second field device (3) arranged in the measurement zone below the semiconductor sample (10) on the side opposed to the surface side illuminated by the light (L), wherein the first field device (2) and the second field device (3) are configured to apply the electric and/or magnetic field and to measure the intermediate parameter.

9. System according to claim 8, wherein the first field device (2) and the second field device (3) are dielectric resonators.

10. System according to one of claims 1 to 9, wherein the contactless measurement means (20) is a resonant measurement means configured to measure a parameter of a resonance peak of the curve as the electrical parameter.

11. System according to one of claims 1 to 10, wherein the contactless measurement means (20) is configured to apply an electrical and/or magnetic field which extends over the complete thickness of the semiconductor sample (10), wherein the semiconductor sample (10) is a semiconductor substrate (10) used to mount MEMS circuits or semiconductor circuits.

12. System according to one of claims 1 to 1 1, wherein the first value measured without the light illumination represents the electrical parameter for the complete thickness of the semiconductor sample, wherein the second value measured with a light penetrating in the sub-layer of the semiconductor and/or being absorbed therein represents the electrical parameter in the semiconductor sample outside of or below the sub-layer, wherein the electrical property is obtained by combining the first value and the second value of the electrical parameter such that the electrical property of the sub-layer is obtained.

13. System according to one of the claims 1 to 12, wherein the electrical parameter is a parameter which is reduced with generation of photo charges by the illumination with the light.

14. Method for measurement of an electrical property of a sub-layer of a semiconductor sample, wherein the semiconductor sample (10) is a semiconductor substrate (10) used to mount MEMS circuits or semiconductor circuits on the semiconductor substrate (10), wherein the method comprises the following steps:
Measuring, with a contactless measurement means, a first value of an electrical parameter of the semiconductor sample in a measurement zone without an illumination of the measurement zone;
measuring, with the contactless measurement means, a second value of the electrical parameter with an illumination of the measurement zone with an illumination means; and
determining, in a processing means, the electrical property of the sub-layer of the semiconductor sample based on the first value and the second value;
wherein the sub-layer whose electrical property is measured corresponds to an absorption layer of the semiconductor sample defined by the penetration depth of the light,
wherein the contactless measurement means (20) for measuring the electrical parameter applies an alternating electric and/or magnetic field in the measurement zone and measures an intermediate parameter based on the influence of the semiconductor sample on the applied electric and/or magnetic field,
**characterized in that**
the contactless measurement means (20) varies the frequency of the applied electric and/or magnetic field in the measurement zone and measures the intermediate parameter at the different varied frequencies to obtain a curve over the field frequency, wherein the electrical parameter is computed based on the intermediate parameter at the different varied frequencies or is calculated based on the curve of the intermediate parameter.

15. Computer program for measuring an electrical property of a sub-layer of a semiconductor sample, wherein the computer program comprises instructions configured to perform the following steps, when executed on a processing means:
determining a first value of an electrical parameter of the semiconductor sample in a measurement zone based on a measurement with a contactless measurement means without an illumination of the measurement zone;
determining a second value of the electrical parameter of the semiconductor sample based on a measurement with the contactless measurement means with an illumination of the measurement zone with an illumination means; and
determining the electrical property of the sub-layer of the semiconductor sample based on the first value and the second value,
wherein the sub-layer whose electrical property is measured corresponds to an absorption layer of the semiconductor sample defined by the penetration depth of the light,
**characterized in that**
the electrical parameter is determined based on a curve of an intermediate parameter over a field frequency measured with the contactless measurement means while varying the frequency of an electric and/or magnetic field applied in the measurement zone.

## Patentansprüche

1. System zur Messung einer elektrischen Eigenschaft einer Unterschicht (15) einer Halbleiterprobe (10):
ein berührungsloses Messmittel (20) zur Messung eines elektrischen Parameters der Halbleiterprobe (10) in einer Messzone, wobei das berührungslose Messmittel so konfiguriert ist, dass es in der Messzone ein elektrisches und/oder magnetisches Wechselfeld anlegt und einen Zwischenparameter auf der Grundlage des Einflusses der Halbleiterprobe auf das angelegte elektrische und/oder magnetische Feld misst, wobei das berührungslose Messmittel (20) so konfiguriert ist, dass es die Frequenz des angelegten elektrischen und/oder magnetischen Feldes in der Messzone variiert;
ein Beleuchtungsmittel (30) zum Beleuchten der Messzone während der Messung mit dem berührungslosen Messmittel (20) mit Licht (L), wobei die Unterschicht (15), deren elektrische Eigenschaft gemessen wird, einer Absorptionsschicht der Halbleiterprobe (10) entspricht, die durch die Eindringtiefe des Lichts (L) definiert ist;
wobei das System so konfiguriert ist, dass es einen ersten Wert des elektrischen Parameters ohne Beleuchtung der Messzone durch das Licht (L) des Beleuchtungsmittels (30) misst und einen zweiten Wert des elektrischen Parameters bei Beleuchtung der Messzone durch das Licht (L) des Beleuchtungsmittels (30) misst;
wobei ein Verarbeitungsmittel (40) so konfiguriert ist, dass es die elektrische Eigenschaft der Unterschicht (15) der Halbleiterprobe (10) auf der Grundlage des ersten Werts und des zweiten Werts bestimmt;
**dadurch gekennzeichnet, dass**
das berührungslose Messmittel (20) so konfiguriert ist, dass es den Zwischenparameter bei den verschiedenen variierten Frequenzen misst, um eine Kurve über die Feldfrequenz zu erhalten, wobei der elektrische Parameter auf der Grundlage des Zwischenparameters bei den verschiedenen variierten Frequenzen berechnet oder auf der Grundlage der Kurve des Zwischenparameters berechnet wird.

2. System nach Anspruch 1, wobei das Beleuchtungsmittel (30) so konfiguriert ist, dass es die Messzone mit mindestens zwei verschiedenen Lichtspektren (B, G, R) beleuchtet, die ein erstes Lichtspektrum und ein zweites Lichtspektrum umfassen, wobei das System so konfiguriert ist, dass es den zweiten Wert des elektrischen Parameters bei Beleuchtung mit dem Licht (L) des ersten Lichtspektrums misst, wobei das System so konfiguriert ist, dass es einen dritten Wert des elektrischen Parameters bei Beleuchtung der Messzone mit dem Licht (L) des zweiten Lichtspektrums misst, wobei das Verarbeitungsmittel (40) so konfiguriert ist, dass es die elektrische Eigenschaft der Unterschicht (15) der Halbleiterprobe (10) mit einer ersten Dicke (D) auf der Grundlage des ersten Werts und des zweiten Werts bestimmt und die elektrische Eigenschaft der Unterschicht (15) der Halbleiterprobe (10) mit einer zweiten Dicke auf der Grundlage des ersten Werts und des dritten Werts bestimmt.

3. System nach Anspruch 2, wobei das Verarbeitungsmittel (40) so konfiguriert ist, dass es die elektrische Eigenschaft einer Tiefenschicht auf der Grundlage des ersten Werts, des zweiten Werts und des dritten Werts bestimmt.

4. System nach einem der Ansprüche 1 bis 3, wobei das System so konfiguriert ist, dass es ein Lichtspektrum oder eine Lichtwellenlänge des Lichts (L) des Beleuchtungsmittels (30) ändert, um die Dicke der Unterschicht (15) zu ändern, deren elektrische Eigenschaft gemessen wird.

5. System nach einem der Ansprüche 1 bis 4, wobei die bestimmte elektrische Eigenschaft der Unterschicht (15) die elektrische Eigenschaft der Unterschicht (15) ohne den Einfluss der Beleuchtung darstellt.

6. System nach einem der Ansprüche 1 bis 5, wobei das berührungslose Messmittel (20) so konfiguriert ist, dass es den elektrischen Parameter unabhängig von einer Modulation des die Absorptionsschicht (15) durchdringenden Lichts (L) berechnet oder misst.

7. System nach einem der Ansprüche 1 bis 6, wobei die Halbleiterprobe (10) eine erste Schicht (11) und mindestens eine Oberflächenschicht (12, 13) umfasst, wobei die erste Schicht (11) einen spezifischen Widerstand von mehr als 1 Kiloohm-Zentimeter aufweist, wobei die mindestens eine Oberflächenschicht (12, 13) auf der ersten Schicht (11) angeordnet ist, wobei die mindestens eine Oberflächenschicht (12, 13) dünner ist als die erste Schicht (11).

8. System nach einem der Ansprüche 1 bis 7, wobei das berührungslose Messmittel (20) eine erste Feldvorrichtung (2) umfasst, die in der Messzone oberhalb der Halbleiterprobe (10) auf der von dem Licht (L) beleuchteten Oberflächenseite der Halbleiterprobe (10) angeordnet ist, wobei das berührungslose Messmittel (20) eine zweite Feldvorrichtung (3) umfasst, die in der Messzone unterhalb der Halbleiterprobe (10) auf der Seite angeordnet ist, die der von dem Licht (L) beleuchteten Oberflächenseite gegenüberliegt, wobei die erste Feldvorrichtung (2) und die zweite Feldvorrichtung (3) so konfiguriert sind, dass sie das elektrische und/oder magnetische Feld anlegen und den Zwischenparameter messen.

9. System nach Anspruch 8, wobei die erste Feldvorrichtung (2) und die zweite Feldvorrichtung (3) dielektrische Resonatoren sind.

10. System nach einem der Ansprüche 1 bis 9, wobei das berührungslose Messmittel (20) ein Resonanzmessmittel ist, das so konfiguriert ist, dass es einen Parameter einer Resonanzspitze der Kurve als den elektrischen Parameter misst.

11. System nach einem der Ansprüche 1 bis 10, wobei das berührungslose Messmittel (20) so konfiguriert ist, dass es ein elektrisches und/oder magnetisches Feld anlegt, das sich über die gesamte Dicke der Halbleiterprobe (10) erstreckt, wobei die Halbleiterprobe (10) ein Halbleitersubstrat (10) ist, das zur Montage von MEMS-Schaltungen oder Halbleiterschaltungen verwendet wird.

12. System nach einem der Ansprüche 1 bis 11, wobei der erste Wert, der ohne Beleuchtung gemessen wird, den elektrischen Parameter für die gesamte Dicke der Halbleiterprobe darstellt, wobei der zweite Wert, der bei in die Unterschicht des Halbleiters eindringendem und/oder darin absorbiertem Licht gemessen wird, den elektrischen Parameter in der Halbleiterprobe außerhalb oder unterhalb der Unterschicht darstellt, wobei die elektrische Eigenschaft durch Kombination des ersten Werts und des zweiten Werts des elektrischen Parameters so ermittelt wird, dass die elektrische Eigenschaft der Unterschicht erhalten wird.

13. System nach einem der Ansprüche 1 bis 12, wobei der elektrische Parameter ein Parameter ist, der sich bei der Erzeugung von Photoladungen durch die Beleuchtung mit dem Licht verringert.

14. Verfahren zur Messung einer elektrischen Eigenschaft einer Unterschicht einer Halbleiterprobe, wobei die Halbleiterprobe (10) ein Halbleitersubstrat (10) ist, das zur Montage von MEMS-Schaltungen oder Halbleiterschaltungen auf dem Halbleitersubstrat (10) verwendet wird, wobei das Verfahren die folgenden Schritte umfasst:
Messen eines ersten Werts eines elektrischen Parameters der Halbleiterprobe in einer Messzone ohne Beleuchtung der Messzone mit einem berührungslosen Messmittel;
Messen eines zweiten Werts des elektrischen Parameters mit dem berührungslosen Messmittel bei Beleuchtung der Messzone durch ein Beleuchtungsmittel; und
Bestimmen der elektrischen Eigenschaft der Unterschicht der Halbleiterprobe in einem Verarbeitungsmittel auf der Grundlage des ersten Werts und des zweiten Werts;
wobei die Unterschicht, deren elektrische Eigenschaft gemessen wird, einer Absorptionsschicht der Halbleiterprobe entspricht, die durch die Eindringtiefe des Lichts definiert ist,
wobei das berührungslose Messmittel (20) zum Messen des elektrischen Parameters ein elektrisches und/oder magnetisches Wechselfeld in der Messzone anlegt und einen Zwischenparameter auf der Grundlage des Einflusses der Halbleiterprobe auf das angelegte elektrische und/oder magnetische Feld misst,
**dadurch gekennzeichnet, dass**
das berührungslose Messmittel (20) die Frequenz des angelegten elektrischen und/oder magnetischen Feldes in der Messzone variiert und den Zwischenparameter bei den verschiedenen variierten Frequenzen misst, um eine Kurve über die Feldfrequenz zu erhalten, wobei der elektrische Parameter auf der Grundlage des Zwischenparameters bei den verschiedenen variierten Frequenzen oder auf der Grundlage der Kurve des Zwischenparameters berechnet wird.

15. Computerprogramm zum Messen einer elektrischen Eigenschaft einer Unterschicht einer Halbleiterprobe, wobei das Computerprogramm Befehle umfasst, die so konfiguriert sind, dass sie bei Ausführung auf einem Verarbeitungsmittel die folgenden Schritte ausführen:
Bestimmen eines ersten Werts eines elektrischen Parameters der Halbleiterprobe in einer Messzone auf der Grundlage einer Messung mit einem berührungslosen Messmittel ohne Beleuchtung der Messzone;
Bestimmen eines zweiten Werts des elektrischen Parameters der Halbleiterprobe auf der Grundlage einer Messung mit dem berührungslosen Messmittel bei Beleuchtung der Messzone mit einem Beleuchtungsmittel; und
Bestimmen der elektrischen Eigenschaft der Unterschicht der Halbleiterprobe auf der Grundlage des ersten Werts und des zweiten Werts,
wobei die Unterschicht, deren elektrische Eigenschaft gemessen wird, einer Absorptionsschicht der Halbleiterprobe entspricht, die durch die Eindringtiefe des Lichts definiert ist,
**dadurch gekennzeichnet, dass**
der elektrische Parameter auf der Grundlage einer mit dem berührungslosen Messmittel gemessenen Kurve eines Zwischenparameters über der Feldfrequenz bestimmt wird, wobei die Frequenz eines in der Messzone angelegten elektrischen und/oder magnetischen Feldes variiert wird..

## Revendications

1. Système de mesure d'une propriété électrique d'une sous-couche (15) d'un échantillon semi-conducteur (10), comprenant :
un moyen de mesure sans contact (20) pour mesurer un paramètre électrique de l'échantillon semi-conducteur (10) dans une zone de mesure, le moyen de mesure sans contact étant conçu pour appliquer un champ électrique et/ou magnétique alternatif dans la zone de mesure et pour mesurer un paramètre intermédiaire en fonction de l'influence de l'échantillon semi-conducteur sur le champ électrique et/ou magnétique appliqué, le moyen de mesure sans contact (20) étant conçu pour faire varier la fréquence du champ électrique et/ou magnétique appliqué dans la zone de mesure,
un moyen d'éclairage (30) pour éclairer la zone de mesure, pendant la mesure réalisée avec le moyen de mesure sans contact (20), au moyen d'une lumière (L), la sous-couche (15) dont la propriété électrique est mesurée correspondant à une couche d'absorption de l'échantillon semi-conducteur (10) définie par la profondeur de pénétration de la lumière (L) ;
le système étant conçu pour mesurer une première valeur du paramètre électrique sans que la zone de mesure soit éclairée par la lumière (L) du moyen d'éclairage (30) et pour mesurer une deuxième valeur du paramètre électrique lorsque la zone de mesure est éclairée par la lumière (L) du moyen d'éclairage (30),
un moyen de traitement (40) étant conçu pour déterminer la propriété électrique de la sous-couche (15) de l'échantillon semi-conducteur (10) en fonction de la première valeur et de la deuxième valeur,
**caractérisé en ce que**
le moyen de mesure sans contact (20) est conçu pour mesurer le paramètre intermédiaire aux différentes fréquences variables afin d'obtenir une courbe sur la fréquence de champ, le paramètre électrique étant calculé en fonction du paramètre intermédiaire à ces différentes fréquences variables ou en fonction de la courbe du paramètre intermédiaire.

2. Système selon la revendication 1, dans lequel le moyen d'éclairage (30) est conçu pour éclairer la zone de mesure avec au moins deux spectres lumineux (B, G, R) différents, comprenant un premier spectre de lumière et un deuxième spectre de lumière, le système étant conçu pour mesurer la deuxième valeur du paramètre électrique lors de l'éclairage par la lumière (L) du premier spectre de lumière, le système étant conçu pour mesurer une troisième valeur du paramètre électrique lors de l'éclairage de la zone de mesure par la lumière (L) du deuxième spectre de lumière, le moyen de traitement (40) étant conçu pour déterminer la propriété électrique de la sous-couche (15) de l'échantillon semi-conducteur (10) d'une première épaisseur (D) en fonction de la première valeur et de la deuxième valeur, et pour déterminer la propriété électrique de la sous-couche (15) de l'échantillon semi-conducteur (10) d'une deuxième épaisseur en fonction de la première valeur et de la troisième valeur.

3. Système selon la revendication 2, dans lequel le moyen de traitement (40) est conçu pour déterminer la propriété électrique d'une couche profonde en fonction de la première valeur, de la deuxième valeur et de la troisième valeur.

4. Système selon l'une quelconque des revendications 1 à 3, ledit système étant conçu pour modifier un spectre de lumière ou une longueur d'onde de lumière (L) du moyen d'éclairage (30) afin de modifier l'épaisseur de la sous-couche (15) dont la propriété électrique est mesurée.

5. Système selon l'une quelconque des revendications 1 à 4, dans lequel la propriété électrique de la sous-couche (15) déterminée représente la propriété électrique de la sous-couche (15) sans influence de la lumière d'éclairage.

6. Système selon l'une quelconque des revendications 1 à 5, dans lequel le moyen de mesure sans contact (20) est conçu pour calculer ou mesurer le paramètre électrique indépendamment d'une modulation de la lumière (L) pénétrant dans la couche d'absorption (15).

7. Système selon l'une quelconque des revendications 1 à 6, dans lequel l'échantillon semi-conducteur (10) comprend une première couche (11) et au moins une couche de surface (12, 13), la première couche (11) présentant une résistivité supérieure à 1 kiloohm-centimètre, la ou les couches de surface (12, 13) étant agencées au-dessus de la première couche (11), et l'au moins une couche de surface (12, 13) étant plus mince que la première couche (11).

8. Système selon l'une quelconque des revendications 1 à 7, dans lequel le moyen de mesure sans contact (20) comprend un premier dispositif de champ (2) agencé dans la zone de mesure au-dessus de l'échantillon semi-conducteur (10), sur le côté de surface de l'échantillon semi-conducteur (10) éclairé par la lumière (L), ledit moyen de mesure sans contact (20) comprenant un deuxième dispositif de champ (3) agencé dans la zone de mesure en dessous de l'échantillon semi-conducteur (10), du côté opposé au côté de surface éclairé par la lumière (L), ledit premier dispositif de champ (2) et ledit deuxième dispositif de champ (3) étant conçus pour appliquer le champ électrique et/ou magnétique et pour mesurer le paramètre intermédiaire.

9. Système selon la revendication 8, dans lequel le premier dispositif de champ (2) et le deuxième dispositif de champ (3) sont des résonateurs diélectriques.

10. Système selon l'une quelconque des revendications 1 à 9, dans lequel le moyen de mesure sans contact (20) est un moyen de mesure résonant conçu pour mesurer, en tant que paramètre électrique, un paramètre d'un pic de résonance de la courbe.

11. Système selon l'une quelconque des revendications 1 à 10, dans lequel le moyen de mesure sans contact (20) est conçu pour appliquer un champ électrique et/ou magnétique qui s'étend sur toute l'épaisseur de l'échantillon semi-conducteur (10), ledit échantillon semi-conducteur (10) étant un substrat semi-conducteur (10) servant au montage de circuits MEMS ou de circuits semi-conducteurs.

12. Système selon l'une quelconque des revendications 1 à 11, dans lequel la première valeur mesurée sans la lumière d'éclairage représente le paramètre électrique relatif à l'épaisseur totale de l'échantillon semi-conducteur, et la deuxième valeur mesurée avec une lumière pénétrant dans la sous-couche du semi-conducteur et/ou absorbée dans celle-ci représente le paramètre électrique propre à l'échantillon semi-conducteur à l'extérieur ou en dessous de la sous couche, ladite propriété électrique étant obtenue par combinaison de la première valeur et de la deuxième valeur du paramètre électrique pour obtenir la propriété électrique de la sous-couche.

13. Système selon l'une quelconque des revendications 1 à 12, dans lequel le paramètre électrique est un paramètre qui diminue lors de la génération de photocharges sous l'effet de l'éclairage par ladite lumière.

14. Procédé de mesure d'une propriété électrique d'une sous-couche d'un échantillon semi-conducteur, l'échantillon semi-conducteur (10) étant un substrat semi-conducteur (10) servant au montage de circuits MEMS ou de circuits semi-conducteurs sur le substrat semi-conducteur (10), le procédé comprenant les étapes suivantes :
la mesure, grâce au moyen de mesure sans contact, d'une première valeur d'un paramètre électrique de l'échantillon semi-conducteur dans une zone de mesure sans que celle-ci soit éclairée,
la mesure, grâce au moyen de mesure sans contact, d'une deuxième valeur du paramètre électrique avec éclairage de la zone de mesure grâce à un moyen d'éclairage, et
la détermination, dans un moyen de traitement, de la propriété électrique de la sous-couche de l'échantillon semi-conducteur en fonction de la première valeur et de la deuxième valeur ;
la sous-couche dont la propriété électrique est mesurée correspondant à une couche d'absorption de l'échantillon semi-conducteur définie par la profondeur de pénétration de la lumière,
ledit moyen de mesure sans contact (20), pour mesurer le paramètre électrique, appliquant un champ électrique et/ou magnétique alternatif dans la zone de mesure et mesurant un paramètre intermédiaire en fonction de l'influence de l'échantillon semi-conducteur sur le champ électrique et/ou magnétique appliqué,
**caractérisé en ce que**
le moyen de mesure sans contact (20) fait varier la fréquence du champ électrique et/ou magnétique appliqué dans la zone de mesure et mesure le paramètre intermédiaire aux différentes fréquences variables afin d'obtenir une courbe sur la fréquence de champ, le paramètre électrique étant calculé en fonction du paramètre intermédiaire à ces différentes fréquences variables ou en fonction de la courbe du paramètre intermédiaire.

15. Programme informatique permettant de mesurer une propriété électrique d'une sous-couche d'un échantillon semi-conducteur, le programme informatique comprenant des instructions conçues pour réaliser les étapes suivantes, lorsqu'elles sont exécutées sur un moyen de traitement :
la détermination d'une première valeur d'un paramètre électrique de l'échantillon semi-conducteur dans une zone de mesure en fonction d'une mesure réalisée avec un moyen de mesure sans contact, sans éclairage de la zone de mesure,
la détermination d'une deuxième valeur du paramètre électrique de l'échantillon semi-conducteur en fonction d'une mesure réalisée avec le moyen de mesure sans contact, la zone de mesure étant éclairée par un moyen d'éclairage, et
la détermination de la propriété électrique de la sous-couche de l'échantillon semi-conducteur en fonction de la première valeur et de la deuxième valeur ;
la sous-couche dont la propriété électrique est mesurée correspondant à une couche d'absorption de l'échantillon semi-conducteur définie par la profondeur de pénétration de la lumière,
**caractérisé en ce que**
le paramètre électrique est déterminé en fonction d'une courbe d'un paramètre intermédiaire sur une fréquence de champ, mesurée avec le moyen de mesure sans contact tandis que varie la fréquence d'un champ électrique et/ou magnétique appliqué dans la zone de mesure.
